# EUROPEAN PATENT SPECIFICATION

(11) **EP 2 372 761 B1**
(45) Date of publication and mention of the grant of the patent: **26.10.2016**
(21) Application number: 11250381.8
(22) Date of filing: 25.03.2011
(51) Int. Cl.: H01L 23/473, H05K 7/20, F28F 3/12, F28F 9/02

(54) **Cold plate with integral structural fluid port**
Kühlplatte mit integralem strukturellem Flüssigkeitsanschluss
Plaque froide dotée d'un port pour fluide structurel intégré

(30) Priority: 29.03.2010 US 748495
(43) Date of publication of application: 05.10.2011
(73) Proprietor: Hamilton Sundstrand Space Systems International, Inc., Windsor Locks, CT 06096 (US)
(72) Inventor: Zaffetti, Mark A., Suffield, Connecticut 06078 (US); Laurin, Michael B., South Hadley, MA 01075 (US); Chabebe, Natalia, Windsor Locks, Connecticut 06096 (US); Taddey, Edmund P., West Springfield, MA 01089 (US)
(74) Representative: Hall, Matthew Benjamin

(56) References cited:
- DE-U1- 20 319 086
- US-A- 5 644 840
- US-A- 5 870 823
- US-A1- 2008 229 580
- US-A1- 2009 107 655

## Description

### BACKGROUND

This disclosure relates to a cold plate used, for example, in cooling electronics or avionics.

In cold plate designs, the cooling fluid is typically routed to the cold plate via system level tubing. A heat generating device for which cooling is desired is mounted to the cold plate, which removes heat from the heat generating device. The cold plate includes multiple sheets secured to one another, typically by a brazing material. Passages are provided in the cold plate for carrying a cooling fluid. The cold plate includes one or more fluid ports secured to a top sheet, for example, to fluidly communicate fluid between the system level tubing to the cold plate.

In some cases, to reduce the potential for leakage between the system level tubing and the fluid ports, couplings are not used but instead the system level tubing is welded directly to the fluid ports. A system level tube and fluid port must sometimes be cut from one another if the welded joint does not meet the inspection requirements. For aluminum cold plates, the fluid port is welded to the cold plate.

### SUMMARY

According to a first aspect of the present invention, there is provided a cold plate assembly comprising a first sheet having an aperture; a second sheet secured to the first sheet; and a fluid port including a body having passage, and a flange extending from the body and secured to the first sheet with a material, the passage and aperture being in fluid communication with one another, wherein the fluid port includes a first locating feature cooperating with the first sheet and configured to locate the fluid port in a desired position relative to the first sheet, and wherein the first locating feature is a protrusion extending from the flange in a direction opposite the body, the protrusion being received within the aperture, and wherein a second locating feature is provided by a periphery of the flange, an edge at the second sheet abutting at least a portion of the periphery. According to a second aspect of the present invention, there is provided a method of manufacturing a cold plate assembly comprising arranging a first sheet and a second sheet relative to one another with a first material provided between the sheets; arranging a fluid port on one of the sheets with a passage of the fluid port in fluid communication with an aperture in the first sheet, the arranging step including locating the fluid port relative to the sheets with a locating feature, the locating feature including a fluid port flange perimeter cooperating with an edge of the second sheet; and a protrusion extending from the fluid port and received within the aperture; providing a second material between the fluid port and at least one of the sheets; and securing the fluid port and sheets to one another with the first and second materials while loading the fluid port and the sheets.

### BRIEF DESCRIPTION OF THE DRAWINGS

The disclosure can be further understood by reference to the following detailed description when considered in connection with the accompanying drawings wherein:
Figure 1 is a schematic, exploded view of a cold plate assembly and a structural assembly.
Figure 2 is a perspective view of an example cold plate assembly.
Figure 3 is a side elevational view of the cold plate assembly shown in Figure 2.
Figures 4A-4B are respectively perspective and cross-sectional views of one example fluid port.
Figures 5A-5C are respectively perspective, cross-sectional and end views of another example fluid port.
Figure 6 is a partial cross-sectional view of the cold plate assembly shown in Figure 2.

### DETAILED DESCRIPTION

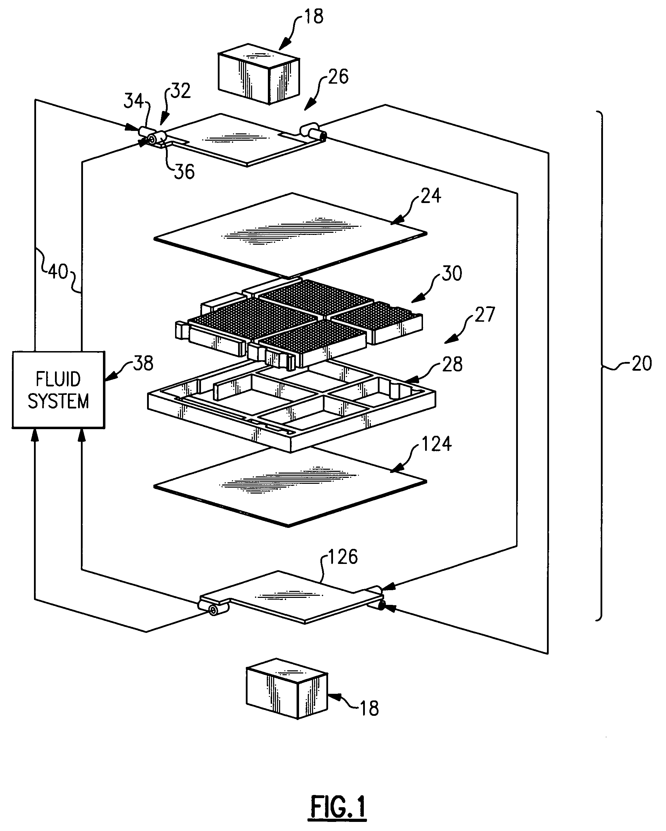

Figure 1 schematically illustrates a structural cold plate assembly 20. The cold plate assembly 20 generally includes a first face sheet 24 with a first cold plate 26 and a second face sheet 124 with a second cold plate 126. The first face sheet 24 and the second face sheet 124 are mounted on opposing sides of a structure 27, such as a frame 28 and a honeycomb core 30, using an adhesive, for example. It should be understood that either or both of face sheets 24, 124 may be a portion of any structure inclusive of a heat generating device 18, such as electronics or avionics.

A header assembly 32, which includes a first port 34 and a second port 36, for example, communicates fluid through the cold plate 26. The first and second ports 34, 36 may be aluminum, for example. The header assembly 32 communicates with a fluid system 38 via system level tubing 40, as generally understood.

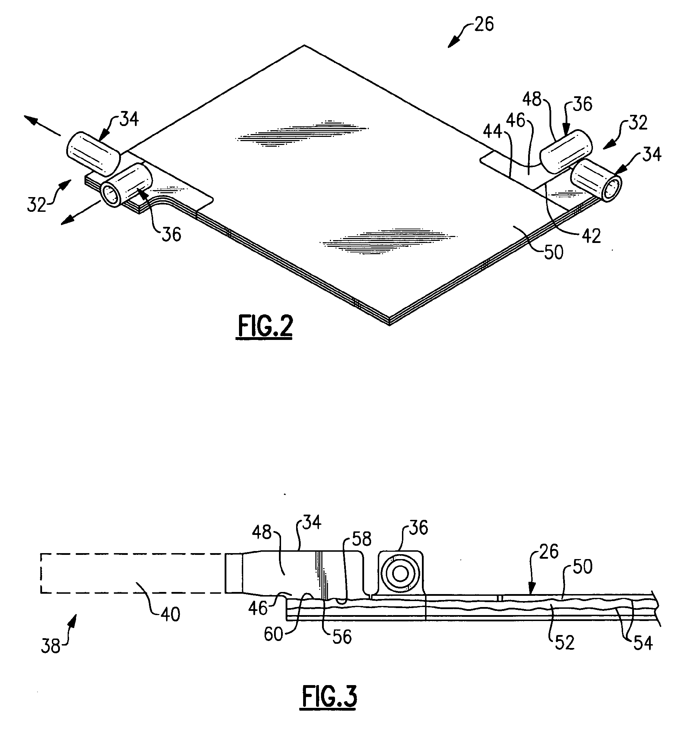

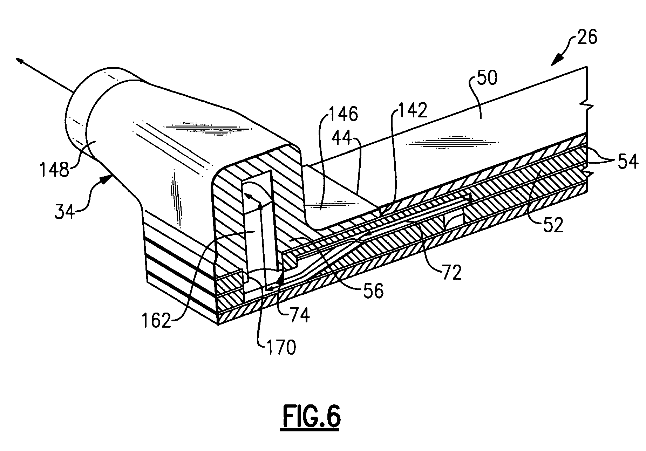

Referring to Figures 3 and 6, the cold plate 26 generally includes a first sheet 50, a second sheet 52, amongst other components, secured together by a first material 54, which is a brazing material in one example. The sheets 50 and 52 of the cold plate 26 are arranged to provide an internal cold plate passage 72 (Figure 6).

In one example embodiment, the first sheet 50 may be manufactured of 3004 aluminum with a nominal thickness of 0.04 inches (1 mm), the first material 54 may be manufactured of a braze material, such as CT-23, or a Multiclad alloy with a nominal thickness of 0.016 inches (0.4 mm), and the second sheet 52 may be manufactured of 6951 aluminum with a nominal thickness of 0.05 inches (1.3 mm). It should be understood that various materials and nominal thickness may alternatively be utilized. The first material 54 may include a braze alloy that melts during a brazing process that forms an integral assembly between the first and second sheets 50, 52. It should be understood that other bonding or assembly methods may alternatively or additionally be utilized.

Referring to Figures 2 and 3, the cold plate 26 is illustrated in more detail. In the example shown, the first and second fluid ports 34, 36 are arranged on opposite corners of the cold plate 26. It should be understood, however, that the fluid ports 34, 36 may be arranged in any suitable location. A system level tubing 40 (Figure 3) is secured to each of the fluid ports, typically by welding. Returning to Figure 2, the fluid ports 34, 36 include one or more locating features that are used to locate the fluid ports 34, 36 relative to the cold plate 26 during manufacturing. In one example, the fluid port 34 includes a flange 46 having a periphery 42. The periphery 42 abuts an edge 44 of the first sheet 50. The edge 44 and at least a portion of the periphery 42 are of a complementary shape to one another such that the periphery 42 and edge 44 laterally locate the fluid port 34 relative to the cold plate 26.

As discussed above, the first and second sheets 50, 52 of the cold plate 26 are secured to one another using a first material 54, which in one example is a brazing material. A second material 56 is provided between a flange surface 58 of the flange 46 and a sheet surface 60 of the second sheet 52. In one example, the second material 56 is a brazing material, which may be the same as the first material 54. The relatively large planar area of the flange and sheet surfaces 58, 60 provides good bonding and structural integrity.

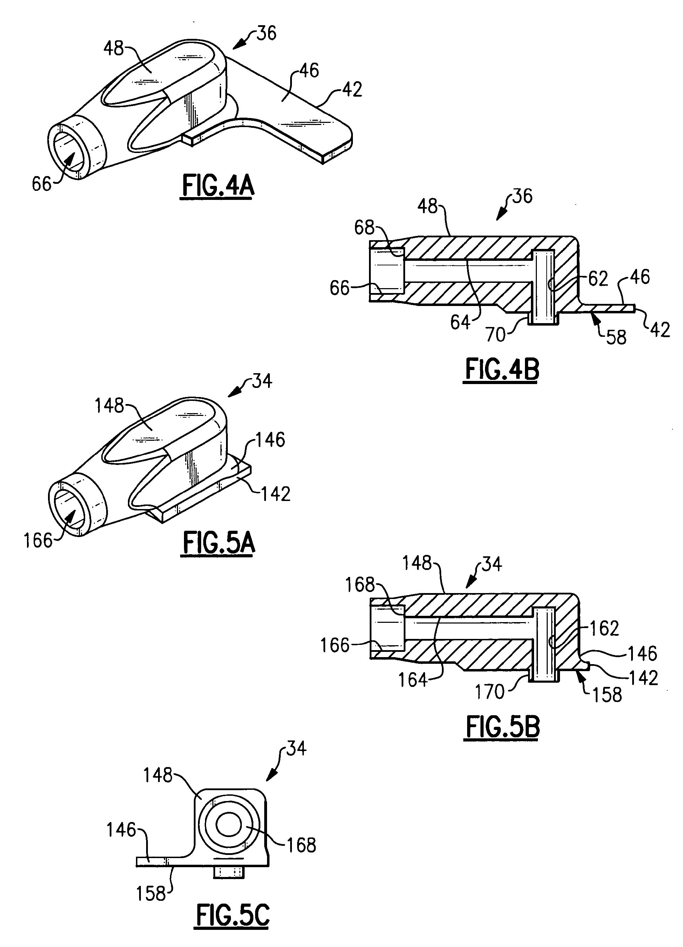

Referring to Figures 4A-4B, the first fluid port 36 includes a body 48 providing first and second fluid passage 62, 64 in fluid communication with one another. The flange 46 extends from and is integral with the body 48. In the example shown, the first and second fluid passages 62, 64 are transversely arranged relative to one another. The second passage 64 includes an opening 66 providing a shoulder 68 that receives an end of the system level tubing 40, for example. A protrusion 70 extends from the flange surface 58 to provide another locating feature, which will be discussed in further detail with respect to Figure 6.

The second fluid port 34 is illustrated in more detail in Figures 5A-5C. The second fluid port 34 is of a similar configuration to that of the first fluid port 36. In the example, the flange 146 of the second fluid port 34 is of a different shape than that of the flange 46 of the first fluid port 36. At least a portion of peripheries 42, 142 (Figure 4) abut one another in the example to laterally locate one another. The second fluid port 34 includes a body 148 providing first and second fluid passage 162, 164 in fluid communication with one another. In the example shown, the first and second fluid passages 162, 164 are transversely arranged relative to one another. The second fluid passage 164 includes an opening 166 providing a shoulder 168 that receives an end of the system level tubing 40, for example.

The second fluid port 34 is shown secured to the second sheet 52 of the cold plate 26 in Figure 6. The protrusion 170 is received in an aperture or hole 74 in the second sheet 52. The passages of the second fluid port 34 are in fluid communication with the hole 74 and the cold plate passage 72 to communicate fluid from the fluid system 38 via the system level tubing 40 to the cold plate 26.

During manufacturing, a load is placed on the individually stacked components prior to the assembly entering the braze furnace to ensure close contact between the individual components and the braze alloy that exist between them. Various methods can be used to apply this load. For example, springs may be used to supply this load or, in another example, weights may be used to provide this load. In this latter case, one or more weights can be applied to the ports during brazing, and those weights may be independently configured relative to loads applied to other areas of the cold plate. This load is applied throughout the thermal brazing cycle and removed when the assembly is taken out of the furnace. The resulting procedure creates a monolithic brazed assembly.

Although an example embodiment has been disclosed, a worker of ordinary skill in this art would recognize that certain modifications would come within the scope of the claims. For that reason, the following claims should be studied to determine their true scope and content.

## Claims

1. A cold plate assembly (20) comprising:
a first sheet (52) having an aperture (74);
a second sheet (50) secured to the first sheet (52); and
a fluid port (34,36) including a body (48;148) having passage (62,64;162,164), and a flange (46;146) extending from the body (48;148) and secured to the first sheet (52) with a material (56), the passage (62,64;162,164) and aperture (74) being in fluid communication with one another,
wherein the fluid port (34,36) includes a first locating feature cooperating with the first sheet (52) and configured to locate the fluid port (34,36) in a desired position relative to the first sheet (52), and wherein the first locating feature is a protrusion (70;170) extending from the flange (46;146) in a direction opposite the body (48;148), the protrusion (70;170) being received within the aperture (74), and
wherein a second locating feature is provided by a periphery (42;142) of the flange (46;146), an edge (44) at the second sheet (50) abutting at least a portion of the periphery (42,142).

2. The cold plate assembly (20) according to claim 1, wherein the first sheet (52) provides a planar surface (60), and the fluid port (34,36) is arranged on the planar surface (60), the flange (46;146) being parallel to the planar surface (60).

3. The cold plate assembly (20) according to claim 1 or 2, wherein the flange (46;146) and the body (48;148) are integral with one another forming a unitary structure.

4. The cold plate assembly (20) according to claim 1, 2 or 3, wherein the passage (62,64;162,164) includes first (62;162) and second (64;164) passages arranged transverse to one another.

5. The cold plate assembly (20) according to any preceding claim, wherein the material (56) is a brazing material.

6. The cold plate assembly according to any preceding claim, wherein the second sheet (50) is secured to the first sheet (52) with a second material (54), and the second material is a brazing material.

7. The cold plate assembly according to any preceding claim, comprising a tube (40) secured to the body (48;148) and in fluid communication with the passage (62,64; 162,164).

8. A method of manufacturing a cold plate assembly comprising:
arranging a first sheet (52) and a second sheet (50) relative to one another with a first material (54) provided between the sheets;
arranging a fluid port (34,36) on one of the sheets (50, 52) with a passage (62,64;162,164) of the fluid port in fluid communication with an aperture (74) in the first sheet (52), the arranging step including locating the fluid port (34,36) relative to the sheets (50, 52) with a locating feature, the locating feature including:
a fluid port flange perimeter (42;142) cooperating with an edge (44) of the second sheet (50); and
a protrusion (70;170) extending from the fluid port (34,36) and received within the aperture (74);
providing a second material (56) between the fluid port (34,36) and at least one of the sheets (50,52); and
securing the fluid port (34,36) and sheets (50,52) to one another with the first and second materials (54,56) while loading the fluid port (34,36) and the sheets (50,52).

9. The method according to claim 8, wherein the first arranging step includes locating the sheets (50,52) relative to one another within a form.

10. The method according to claim 8 or 9, comprising the step of heating the first and second materials (54,56) during the securing step wherein the first and second materials (54,46) are the same and preferably are a brazing material.

## Patentansprüche

1. Kaltplattenbaugruppe (20), umfassend:
ein erstes Blech (52) mit einer Öffnung (74);
ein zweites Blech (50), das am ersten Blech (52) befestigt ist; und
einen Fluidanschluss (34, 36) mit einem Körper (48; 148), der einen Durchlass (62, 64; 162, 164) aufweist, und einem Flansch (46; 146), der sich von dem Körper (48; 148) erstreckt und mit einem Material (56) am ersten Blech (52) befestigt ist, wobei der Durchlass (62, 64; 162,164) und die Öffnung (74) in Fluidverbindung miteinander stehen,
wobei der Fluidanschluss (34, 36) ein erstes Positionierungsmerkmal beinhaltet, das mit dem ersten Blech (52) zusammenwirkt und dazu ausgestaltet ist, den Fluidanschluss (34, 36) in einer gewünschten Position im Verhältnis zum ersten Blech (52) anzuordnen, und wobei das erste Positionierungsmerkmal ein Vorsprung (70; 170) ist, der sich von dem Flansch (46; 146) in einer Richtung entgegengesetzt zum Körper (48; 148) erstreckt, wobei der Vorsprung (70; 170) in der Öffnung (74) aufgenommen ist, und
wobei ein zweites Positionierungsmerkmal durch einen Umfang (42; 142) des Flansches (46; 146) bereitgestellt wird, wobei eine Kante (44) am zweiten Blech (50) wenigstens an einem Abschnitt des Umfangs (42, 142) anliegt.

2. Kaltplattenbaugruppe (20) nach Anspruch 1, wobei das erste Blech (52) eine ebene Fläche (60) bereitstellt und der Fluidanschluss (34, 36) an der ebenen Fläche (60) angeordnet ist, wobei der Flansch (46; 146) parallel zur ebenen Fläche (60) ist.

3. Kaltplattenbaugruppe (20) nach Anspruch 1 oder 2, wobei der Flansch (46; 146) und der Körper (48; 148) einstückig miteinander sind und eine einteilige Struktur bilden.

4. Kaltplattenbaugruppe (20) nach Anspruch 1, 2 oder 3, wobei der Durchlass (62, 64; 162, 164) einen ersten (62; 162) und einen zweiten (64; 164) Durchlass beinhaltet, die quer zueinander angeordnet sind.

5. Kaltplattenbaugruppe (20) nach einem der vorangehenden Ansprüche, wobei das Material (56) ein Hartlötmaterial ist.

6. Kaltplattenbaugruppe nach einem der vorangehenden Ansprüche, wobei das zweite Blech (50) mit einem zweiten Material (54) am ersten Blech (52) befestigt ist und das zweite Material ein Hartlötmaterial ist.

7. Kaltplattenbaugruppe nach einem der vorangehenden Ansprüche, umfassend ein Rohr (40), das am Körper (48; 148) befestigt ist und mit dem Durchlass (62, 64; 162, 164) in Fluidverbindung steht.

8. Verfahren zum Herstellen einer Kaltplattenbaugruppe, umfassend:
Anordnen eines ersten Blechs (52) und eines zweiten Blechs (50) relativ zueinander, wobei ein erstes Material (54) zwischen den Blechen vorgesehen ist;
Anordnen eines Fluidanschlusses (34, 36) an einem der Blech (50, 52), wobei ein Durchlass (62, 64; 162, 164) in Fluidverbindung mit einer Öffnung (74) im ersten Blech (52) steht, wobei der Schritt des Anordnens das Positionieren des Fluidanschlusses (34, 36) im Verhältnis zu den Blechen (50, 52) mittels eines Positionierungsmerkmals beinhaltet, wobei das Positionierungsmerkmal Folgendes beinhaltet:
einen Fluidanschlussflanschdurchmesser (42; 142), der mit einer Kante (44) des zweiten Blechs (50) zusammenwirkt; und
einen Vorsprung (70; 170), der sich von dem Fluidanschluss (34, 36) erstreckt und in der Öffnung (74) aufgenommen wird;
Bereitstellen eines zweiten Materials (56) zwischen dem Fluidanschluss (34, 36) und wenigstens einem der Bleche (50, 52); und
Befestigen des Fluidanschlusses (34, 36) und der Bleche (50, 52) aneinander mittels des ersten und zweiten Materials (54, 56), während der Fluidanschluss (34, 36) und die Bleche (50, 52) belastet werden.

9. Verfahren nach Anspruch 8, wobei der erste Anordnungsschritt das Positionieren der Bleche (50, 52) im Verhältnis zueinander in einer Form beinhaltet.

10. Verfahren nach Anspruch 8 oder 9, umfassend den Schritt des Erwärmens des ersten und zweiten Materials (54, 56) während des Befestigungsschritts, wobei das erste und zweite Material (54, 56) gleich sind und vorzugsweise ein Hartlötmaterial sind.

## Revendications

1. Ensemble de plaque froide (20) comprenant :
une première tôle (52) ayant une ouverture (74) ;
une seconde tôle (50) fixée sur la première tôle (52) ; et
un orifice de fluide (34,36) comprenant un corps (48;148) ayant un passage (62, 64; 162, 164) et une bride (46;146) se prolongeant à partir du corps (48;148) et fixée sur la première tôle (52) avec un matériau (56), le passage (62,64;162,164) et l'ouverture (74) étant en communication fluidique l'un avec l'autre,
dans lequel l'orifice de fluide (34,36) comprend une première caractéristique de positionnement coopérant avec la première tôle (52) et configurée pour positionner l'orifice de fluide (34,36) dans une position souhaitée par rapport à la première tôle (52), et dans lequel la première caractéristique de positionnement est une saillie (70;170) se prolongeant à partir de la bride (46;146) dans un sens opposé au corps (48;148), la saillie (70;170) venant se loger à l'intérieur de l'ouverture (74), et
dans lequel une seconde caractéristique de positionnement est fournie par une périphérie (42;142) de la bride (46;146), un bord (44) au niveau de la seconde tôle (50) venant en butée contre au moins une partie de la périphérie (42, 142).

2. Ensemble de plaque froide (20) selon la revendication 1, dans lequel la première tôle (52) fournit une surface plane (60), et un orifice de fluide (34,36) se trouve sur la surface plane (60), la bride (46;146) étant parallèle à la surface plane (60).

3. Ensemble de plaque froide (20) selon la revendication 1 ou 2, dans lequel la bride (46;146) et le corps (48;148) sont solidaires l'une par rapport à l'autre et forment une structure unitaire.

4. Ensemble de plaque froide (20) selon la revendication 1, 2 ou 3, dans lequel le passage (62,64;162,164) comprend des premier (62;162) et second (64;164) passages disposés transversalement les uns par rapport aux autres.

5. Ensemble de plaque froide (20) selon une quelconque revendication précédente, dans lequel le matériau (56) est un matériau de brasage.

6. Ensemble de plaque froide selon une quelconque revendication précédente, dans lequel la seconde tôle (50) est fixée sur la première tôle (52) avec un second matériau (54), et le second matériau est un matériau de brasage.

7. Ensemble de plaque froide selon une quelconque revendication précédente, comprenant un tube (40) fixé sur le corps (48;148) et en communication fluidique avec le passage (62, 64; 162, 164).

8. Procédé de fabrication d'un ensemble de plaque froide comprenant :
l'agencement d'une première tôle (52) et d'une seconde tôle (50) l'une par rapport à l'autre avec un premier matériau (54) prévu entre les tôles ;
l'agencement d'un orifice de fluide (34,36) sur l'une des tôles (50, 52) avec un passage (62,64; 162,164) de l'orifice de fluide en communication fluidique avec une ouverture (74) dans la première tôle (52), l'étape d'agencement comprenant le positionnement de l'orifice de fluide (34,36) par rapport aux tôles (50, 52) avec une caractéristique de positionnement, la caractéristique de positionnement comprenant :
un périmètre de bride d'orifice de fluide (42;142) coopérant avec un bord (44) de la seconde tôle (50) ; et
une saillie (70;170) se prolongeant à partir de l'orifice de fluide (34,36) et logée à l'intérieur de l'ouverture (74) ;
la fourniture d'un second matériau (56) entre l'orifice de fluide (34,36) et au moins l'une des tôles (50,52) ; et
la fixation de l'orifice de fluide (34,36) et des tôles (50,52) l'un par rapport aux autres avec les premier et second matériaux (54,56) pendant le chargement de l'orifice de fluide (34,36) et des tôles (50, 52).

9. Procédé selon la revendication 8, dans lequel la première étape d'agencement comprend le positionnement des tôles (50,52) les unes par rapport aux autres à l'intérieur d'une forme.

10. Procédé selon la revendication 8 ou 9, comprenant l'étape consistant à chauffer les premier et second matériaux (54,56) pendant l'étape de fixation dans lequel les premier et second matériaux (54,46) sont identiques et sont de préférence un matériau de brasage.
